Europäisches Patentamt

(19) European Patent Office

Office européen des brevets

(11) Publication number: **0 089 636**
**B1**

(12) **EUROPEAN PATENT SPECIFICATION**

(45) Date of publication of patent specification: **11.03.87**

(21) Application number: **83102677.8**

(22) Date of filing: **18.03.83**

(51) Int. Cl.⁴: **H 05 K 13/00**

(54) **Apparatus for clamping dual pin type electronic parts.**

(30) Priority: **23.03.82 JP 46121/82**

(43) Date of publication of application:
**28.09.83 Bulletin 83/39**

(45) Publication of the grant of the patent:
**11.03.87 Bulletin 87/11**

(84) Designated Contracting States:
**DE FR GB**

(56) References cited:
**DE-B-2 813 481**
**GB-A- 944 953**
**US-A-3 538 580**
**US-A-3 640 519**
**US-A-3 757 406**
**US-A-3 874 443**

(73) Proprietor: **IDEYA Co., Ltd.**
**No. 8 Minaminakajo Haze**
**Kizu-cho Soraku-gun Kyoto, 619-02 (JP)**

(72) Inventor: **Fukuda, Yoshinori**
**2-27, Shinmori 5-chome**
**Asahi-ku Osaka (JP)**

(74) Representative: **Patentanwälte Dipl.-Ing. W.**
**Dahlke Dipl.-Ing. H.-J. Lippert**
**Frankenforster Strasse 137**
**D-5060 Bergisch Gladbach 1 (DE)**

Courier Press, Leamington Spa, England.

## Description

The present invention relates to an apparatus for clamping dual pin type electronic parts, in particular for use in a solder dipping system, comprising at least one pair of chuck members oppositely located with respect to each other and pivotably arranged to receive and to release a dual pin type electronic part therebetween and opening and closing means for pivoting the chuck members.

Known apparatuses for clamping dual pin type electronic parts essentially make use of a chuck with only one pair of chuck members and an opening and closing means designed and correlated to the chuck in such a way that its vertical reciprocation opens and closes the upper end of the chuck to thereby clamp and release an electronic part by the lower end of the chuck.

Such an apparatus is known from the DE—B—2 813 481. The chuck disclosed in this document consists of two clamp arms and webs which project laterally and perpendicularly from these clamp arms. The clamp arms and the webs are arranged so that the ends of the webs which are averted from the clamp arms are pivotably connected to a common clamp shaft. The opening and closing means comprises a pull rod with a spreader arranged between the upper ends of the clamp arms. By means of compression springs the upper ends of the clamp arms are biased against the spreader of the pull rod. An upward movement of the pull rod effects spreading of the upper ends of the clamp arms and, hence, clamping of the electronic parts by the chuck members, the lower ends of the clamp arms.

The prior art apparatus is designed for processing only one electronic part. Modern quantity treatment of electronic parts, however, requires the processing of a plurality of electronic parts at the same time. If f.i. the lead pins of dual pin type electronic parts, DIP (dual inline package) type IC (integrated circuit) etc., are to be dipped by solder, cleaned and dried within an automatic solder dipping system, a more effective in-line treatment of a plurality of electronic parts is desirable. The construction of the prior art apparatus, however, is inadequate to clamp and transport a plurality of electronic parts in line without giving damage to the electronic parts, and to hold the electronic parts positively.

It was, therefore, needed to provide a clamping apparatus which has simple structure and can clamp the electronic parts positively.

Accordingly, it is the object of the present invention to provide a clamping apparatus which can clamp a plurality of dual pin type electronic parts in line at the same time without giving damage to the electronic parts and to hold the electronic parts positively.

This object is achieved by providing the clamping apparatus with a pair of parallel clamp shafts, journaled by bearings and operatively connected to the opening and closing means to rotate said clamp shafts, a pair of chuck mounting rods, each of which is mounted radially to one of said clamp shafts, a plurality of chuck members mounted in line on each of said chuck mounting rods, each pair of opposing chuck members being arranged to receive a dual pin type electronic part at the end surfaces from which no lead pins project outwardly, and a spring means attached at each end to each of said chuck mounting rods for biasing said clamp shafts to rotate each pair of said opposing chuck members towards one another, such that each pair of said opposing chuck members is closable to clamp both end surfaces of a dual pin type electronic part therebetween.

By means of the construction of the apparatus according to the invention, a plurality of dual pin type electronic parts can be clamped in line at the same time and the clamping can be performed in a smooth and uniform way so that the electronic parts are not damaged and are held positively.

In a preferred embodiment of the invention the chuck members are made of resilient materials. In this way the favourable clamping properties of the apparatus are further improved.

The opening and closing means may be designed to include a lifting device which pushes a lever projected radially from one of said clamp shafts to rotate said clamp shaft, said clamp shafts having a pair of gears which mesh with each other to rotate said clamp shaft synchronously to reverse directions with respect to each other against the biasing force of said spring means to open and close said chuck members. By means of the synchronous movement of each pair of chuck members towards one another, attained by this construction, a most favourable symmetric clamping can be achieved.

The lifting device may consist of an elevating rod movable upwardly by a cylinder. This design of the lifting device is particularly advantageous for use in an automatic system for processing the electronic parts.

The above and other objects and features of the present invention will become more apparent when referred to the following descriptions stated in conjunction with the accompanying drawings, wherein like reference numerals denote like elements and in which:

Fig. 1 is a descriptive view of a prior clamping apparatus showing an electronic part in the clamped condition;

Fig. 2 is a perspective view showing an example of a dual pin type electronic part;

Fig. 3 is a partial perspective view of chuck members used in the present invention;

Fig. 4 is a sectional view of the clamping apparatus in accordance with one embodiment of the present invention;

Fig. 5 is a front elevational view of the clamping apparatus shown in Fig. 4 in small scale;

Fig. 6 is a plan view of the clamping apparatus shown in Fig. 5;

Fig. 7 is a partial perspective view showing one example of a mounting table for mounting thereon dual pin type electronic parts according to the present invention;

Fig. 8 is a diagrammatic plan view showing one example of a solder dipping system for dual pin type electronic parts, in which the clamping apparatus of the present invention can be incorporated.

Detailed Description of the Preferred Embodiment

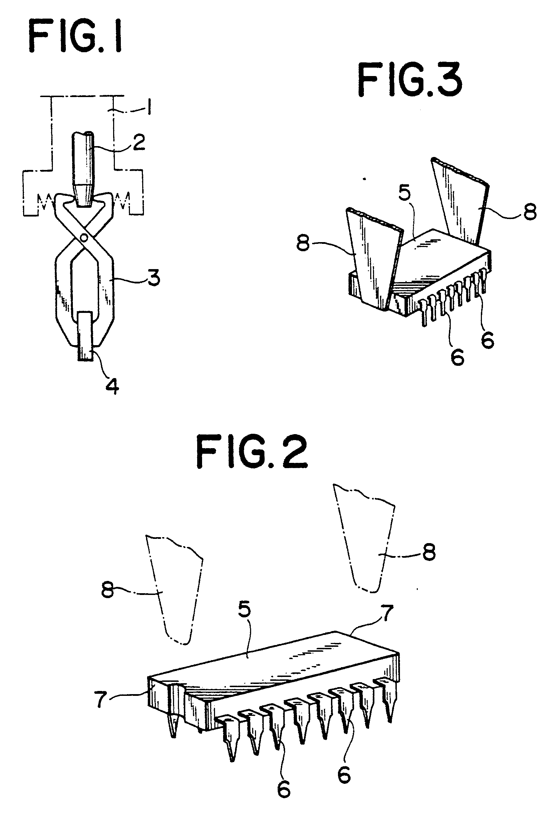

Referring now to the drawings, Fig. 2 is a perspective view of a DIP type IC shown as a typical example of dual pin type electronic parts 5. When the lead pins or outer leads 6 of the electronic parts 5 are dipped by solder, or cleaned and dried after the solder dipping, a plurality of electronic parts 5 should be clamped for transporting or handling.

For clamping the electronic parts 5, the inventor perceived to the outer periphery, especially both ends 7 of the electronic parts 5 where no lead pins 6 are provided, as the objective position of the clamping by the clamping apparatus, and perfected the present invention. Namely, clamping of a plurality of dual pin type electronic parts 5 is performed by holding the both ends 7 of the electronic parts 5 by a pair of chuck members or chuck nail plates 8 of the clamping apparatus. As the result, it is possible to clamp the electronic part 5 without giving damages to the lead pins 6 which are important portions of the electronic part 5.

The clamping apparatus of the present invention which clamps, for example, above mentioned dual pin type electronic parts 5 includes, as described above, two parallel arms supported by bearings and correlated to opening and closing means, and at least one pair of chuck members 8 attached to the underside of the arms directly or via a mounting member, the chuck member 8 can clamp both ends of the dual pin type electronic part and preferably made of resilient or flexible materials.

This clamping apparatus is mounted on the position for handling the dual pin type electronic parts 5, for example, on the rotary table of an automatic solder dipping system. In the clamping apparatus, by operating the above described opening and closing means, for example, a tension spring and arm rotating means which rotate two parallel arms outwardly or inwardly by a predetermined angle at the same time, the chuck members 8 mounted to the underside of the arms are opened or closed. When the chuck arms 8 are closed, the both ends 7 of the dual pin type electronic parts 5 are clamped between the lower ends of the chuck members 8. The clamping apparatus can clamp and handle automatically a plurality of dual pin type electronic part at a time in order to transport them to the upward and downward directions or right and left directions in accordance with the object to which the clamping apparatus is mounted.

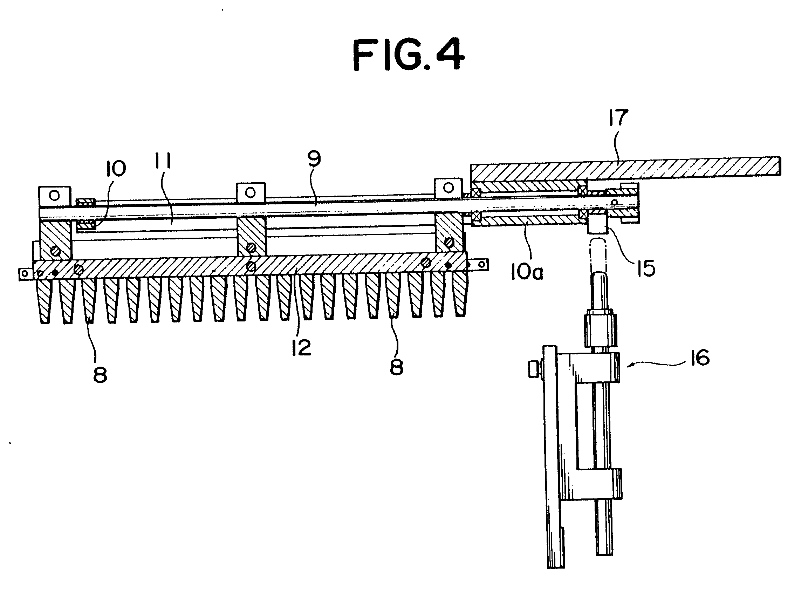

Figs. 4—6 show one embodiment of the clamping apparatus according to the present invention. In this clamping apparatus shown in these figures, the front and the base ends of two parallel clamp shafts 9 are respectively journaled by bearings 10 and 10a, and a mounting portion 11 is fixed to the front projecting portion and other suitable positions.

A pair of chuck mounting rods 12 are provided to the lower end of the mounting portion 11 in parallel relation to the clamp shafts 9. The both ends of the mounting rods 12 are pulled each other by means of each tension spring 13, namely, both of the clamp shafts 9 are energized to rotate inwardly. A pair of gears 14 are mounted on the clamp shafts 9 at the positions projected from the bearing 10a situated at the base ends of the clamp shafts 9, and these gears 14 mesh with each other so that both of the clamp shafts 9 can rotate synchronously. Further, a rotating lever 15 projects towards side direction from one of the clamp shafts 9, and there is provided a lifting device for pushing the lever 15 from the lower position to the upper position, for example, an elevating rod 16 which moves upwardly by a cylinder.

To the underside of the chuck mounting rod 12 having the above driving mechanism, a plurality of chuck members or chuck nail plates 8 which are made of resilient materials such as spring plates or rubber plates etc. are provided in parallel relation.

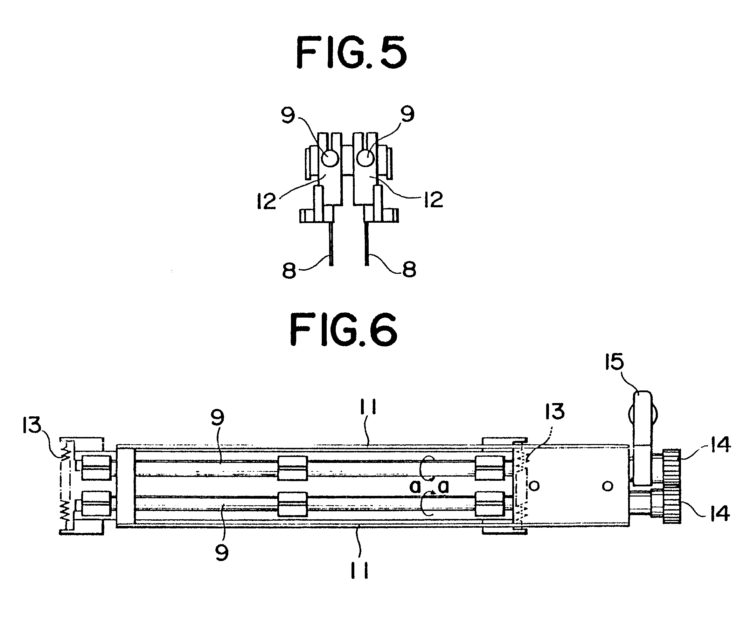

In this arrangement, when the lever 15 of one of the clamp shafts 9 is pushed upwardly by actuating the lifting device 16, each of the two clamp shafts 9 is rotated in the direction shown by arrows a in Fig. 6 to open the chuck members 8 against the tension of the springs 13, and when the actuation of the lifting device 16 is stopped, the chuck members 8 are closed by the tension of the springs 13. Therefore, if the dual pin type electronic parts were positioned between the chuck members in the opened condition, it is possible to clamp and handle a plurality of the electronic parts at one time.

The reference numeral 17 in the drawing shows an object to which one of the bearings, for example, the bearing 10a is mounted. The present clamping apparatus is operated in accordance with the motion of the object 17 so as to handle the dual pin type electronic parts at respective processing stations.

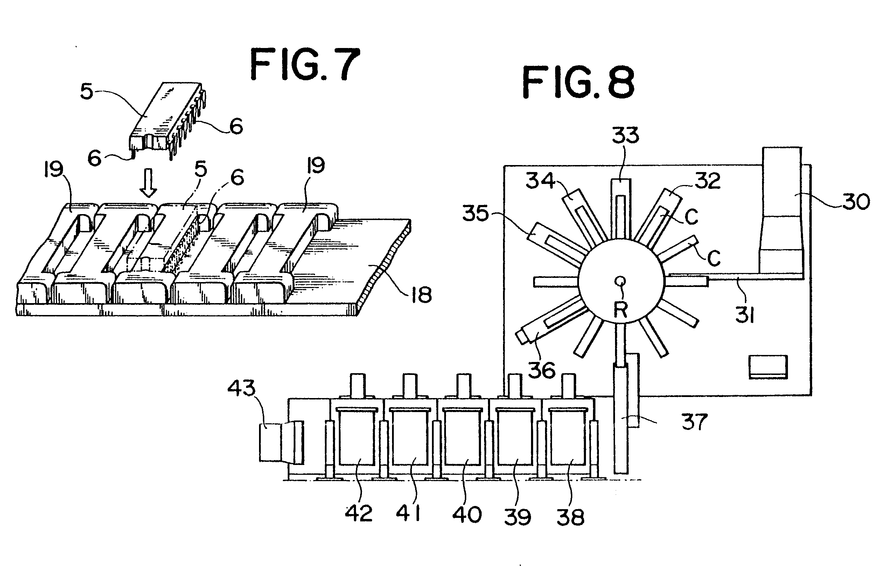

Fig. 7 shows a transporting mechanism in which carriers or mounting tables 19 having substantially H shape in plan view are provided on the upper surface of the endless belt 18 which moves in an endless loop. Onto the upper side of the carriers 19, the dual pin type electronic parts can be mounted. It is possible to handle a plurality of dual pin type electronic parts feeded in line by clamping the end faces of the electronic parts by means of the chuck members 8 of the above described clamping apparatus.

Then, an example in which the clamping apparatus of the present invention is applied to the solder dipping treatment is described hereinafter.

Fig. 8 shows a diagrammatic view of one example of an automatic solder dipping system for dipping solder to the lead pins of dual pin type electronic parts. In this system, a plurality of dual pin type electronic parts fed from a feeding tray 30 are arranged in line at the transporting step etc. and are fed to the feeding station 31. The electronic parts fed successively are transported to the automatic solder dipping system, in which etching tanks 32, 33, a cleaning tank 34, a flux dipping tank 35, a solder dipping tank 36, and a reserve tank (not shown) are arranged in a concentric circle. At the center of tanks, there is provided a rotary shaft R which is correlated to a drive mechanism such as a motor etc.

To the rotary shaft R, the clamping apparatus C of the present invention is connected via a table in correspondence with the arrangement of the above tanks, for example, in the embodiment shown in Fig. 4, the bearing positioned at the base end is connected. The clamping apparatus C is rotated by a predetermined angle by means of the rotation of the rotary shaft R in order to feed the dual pin type electronic parts successively, and the electronic parts are treated by the solder dipping tank 36 etc. correlated to the lifting device at each processing station and elevated by a predetermined height.

After the solder dipping is completed, the electronic parts are fed to a discharge device 37, from which transported and cleaned via cleaner tanks 38, 39, 40 and dried by means of dryer tanks 41, 42, and collected in a tray 43.

As the feeding of the dual pin type electronic parts described above is performed in accordance with the operation of the clamping apparatus of the present invention, when the clamping apparatus is used in the automatic assembling process etc., it is possible to feed the dual pin type electronic parts so that they can be mounted in line.

As described above, the clamping apparatus of the present invention includes the chuck members which can clamp a plurality of dual pin type electronic parts in relation with the opening and closing means to hold and handle them in line for feeding, the clamping apparatus can be used as beneficial automatic feeding and handling means when various treatments such as automatic solder dipping are performed on the dual pin type electronic parts.

## Claims

1. An apparatus for clamping dual pin type electronic parts, in particular for use in a solder dipping system, comprising at least one pair of chuck members oppositely located with respect to each other and pivotably arranged to receive and to release a dual pin type electronic part therebetween and opening and closing means for pivoting the chuck members, characterized by a pair of parallel clamp shafts (9), journaled by bearings (10, 10a) and operatively connected to the opening and closing means to rotate said clamp shafts (9), a pair of chuck mounting rods (12) each of which is mounted radially to one of said clamp shafts (9), a plurality of chuck members (8) mounted in line on each of said chuck mounting rods (12), each pair of opposite chuck members (8) being arranged to receive a dual pin type electronic part (5) at the end surfaces (7) from which no lead pins (6) project outwardly, and a spring means (13) attached at each end to each of said chuck mounting rods (12) for biasing said clamp shafts (9) to rotate each pair of said opposing chuck members (8) towards one another, such that each pair of said opposing chuck members (8) is closable to clamp both end surfaces (7) of a dual pin type electronic part (5) therebetween.

2. An apparatus according to claim 1, characterized in that said chuck members (8) are made of resilient materials.

3. An apparatus according to claim 1 or 2, characterized in that said opening and closing means includes a lifting device (16) for pushing a lever (15) projected radially from one of said clamp shafts (9) to rotate said clamp shafts (9), said clamp shafts (9) having a pair of gears (14) which mesh with each other to rotate said clamp shafts (9) synchronously to reverse directions with respect to each other against the biasing force of said spring means (13) to open and close said chuck members (8).

4. An apparatus according to claim 3, characterized in that said lifting device (16) comprises an elevating rod movable upwardly by a cylinder.

## Patentansprüche

1. Vorrichtung zum Klemmen von elektronischen Unterteilen vom Typ mit zwei Anschlußreihen, insbesondere zur Verwendung in einer Lötmittel-Eintauchvorrichtung, mit wenigstens einem Paar von Einspannteilen, die einander gegenüberliegend und verschwenkbar angeordnet sind, um ein elektronisches Unterteil vom Typ mit zwei Anschlußreihen dazwischen aufzunehmen und loszulassen, und einer Öffnungs- und Schließeinrichtung zum Verschwenken der Einspannteile, gekennzeichnet durch ein Paar von parallelen Klemmwellen (9), die in Lagern (10, 10a) drehbar gelagert und mit der Öffnungs- und Schließeinrichtung wirksam zur Drehung der Klemmwellen (9) verbunden sind, ein Paar von Befestigungsstangen (12), deren jede radial an einer der Klemmwellen (9) angebracht ist, eine Vielzahl von Einspannteilen (8), die in einer Linie an jeder der Befestigungsstangen (12) angebracht sind, wobei jedes Paar von gegenüberliegenden Einspannteilen (8) so angeordnet ist, daß es ein elektronisches Unterteil vom Typ mit zwei Anschlußreihen (5) an den Stirnseiten (7), an denen keine Anschlüsse (6) nach außen vorstehen, aufnimmt, und eine Federeinrichtung (13), die an jedem Ende an jeder der Befestigungsstangen (12) angebracht ist, um die Klemmwellen (9) zum Gegeneinanderschwenken jedes Paares von gegenüberliegenden Einspannteilen (8) vorzuspannen, so daß jedes Paar von gegenüberliegenden Einspannteilen (8) schließbar ist, um die beiden Stirnseiten (7) eines elektronischen Unterteils vom Typ mit zwei Anschlußreihen (5) dazwischen einzuklemmen.

2. Vorrichtung nach Anspruch 1, dadurch gekennzeichnet, daß die Einspannteile (8) aus elastischen Materialien gefertigt sind.

3. Vorrichtung nach Anspruch 1 oder 2, dadurch gekennzeichnet, daß die Öffnungs- und Schließeinrichtung eine Hebevorrichtung (16) zur Betätigung eines von einer der Klemmwellen (9) radial vorstehenden Hebels (15) zur Drehung der Klemmwellen (9) aufweist, wobei die Klemmwellen (9) ein Paar von Zahnrädern (14) haben, die im Eingriff miteinander stehen, um die Klemmwellen (9) synchron in einander entgegengesetzten Richtungen gegen die Vorspannkraft der Federeinrichtung (13) zum Öffnen und Schließen der Einspannteile (8) zu drehen.

4. Vorrichtung nach Anspruch 3, dadurch gekennzeichnet, daß die Hebevorrichtung (16) eine durch einen Zylinder nach oben bewegbare Hubstange aufweist.

**Revendications**

1. Appareil pour le serrage de composants électroniques du type à deux rangées de broches de connexion, utilisable en particulier dans un système d'application de soudure par immersion, comprenant au moins une paire de mâchoires de serrage placées l'une en face de l'autre et montées pivotantes de manière à recevoir et à libérer un composant électronique du type à deux rangées de broches de connexion, et des moyens d'ouverture et de fermeture pour faire pivoter les mâchoires de serrage, caractérisé par une paire d'arbres de serrage parallèles (9), montés à pivotement dans des paliers (10, 10a) et reliés fonctionnellement aux moyens d'ouverture et de fermeture pour faire tourner ces arbres de serrage (9), par une paire de barres (12) de montage des mâchoires, dont chacune est montée en position radiale par rapport à l'un des arbres de serrage (9), par plusieurs mâchoires de serrage (8) montées en ligne sur chacune des barres (12) de montage des mâchoires, chaque paire de mâchoires de serrage opposées (8) étant agencée de manière à recevoir un composant électronique (5) du type à deux rangées de broches au niveau des surfaces d'extrémité (7) de celui-ci à partir desquelles aucune broche conductrice (6) ne fait saillie vers l'extérieur, et par des moyens à ressort (13) fixés par chacune de leurs extrémités à chacune des barres (12) de montage des mâchoires pour solliciter les arbres de serrage (9) de telle manière que ceux-ci fassent tourner les mâchoires de serrage opposées (8) de chaque paire l'une vers l'autre, de telle sorte que chaque paire de mâchoires de serrage opposées (8) puisse être fermée pour serrer entre elles les deux surfaces d'extrémité (7) d'un composant électronique (5) du type à deux rangées de broches.

2. Appareil selon la revendication 1, caractérisé en ce que les mâchoires de serrage (8) sont faites de matériaux faisant ressort.

3. Appareil selon la revendication 1 ou 2, caractérisé en ce que les moyens d'ouverture et de fermeture comprennent un dispositif élévateur (16) propre à pousser un levier (15) qui fait saillie radialement sur l'un des arbres de serrage (9) pour faire tourner ces arbres de serrage (9), ces arbres de serrage (9) comportant une paire de roues dentées (14) qui sont en prise l'une avec l'autre pour faire tourner les arbres de serrage (9) en synchronisme, en sens opposé l'un par rapport à l'autre, contre la force de sollicitation des moyens à ressort (13), pour ouvrir et fermer les mâchoires de serrage (8).

4. Appareil selon la revendication 3, caractérisé en ce que le dispositif élévateur (16) comprend une tige élévatrice mobile vers le haut sous l'action d'un vérin.

0 089 636

FIG.1

FIG.3

FIG.2

# FIG.4

# FIG.5

# FIG.6

0 089 636

# FIG.7

# FIG.8